# FASCICULE DE BREVET EUROPEEN

(11) **EP 2 994 764 B1**
(45) Date de publication et mention de la délivrance du brevet: **21.07.2021**
(21) Numéro de dépôt: 14729399.7
(22) Date de dépôt: 07.05.2014
(51) Int. Cl.: G01R 31/00, G01R 31/11, G01R 1/04, G01R 31/52, G01R 31/54

(54) **ORGANE DE CONNEXION ÉLECTRIQUE POUR LA DÉTECTION DE DISCONTINUITÉS DANS UN RÉSEAU ÉLECTRIQUE**
ELEKTRISCHES VERBINDUNGSELEMENT ZUR DETEKTION VON DISKONTINUITÄTEN IN EINEM ELEKTRISCHEN NETZ
ELECTRICAL CONNECTION MEMBER FOR DETECTING DISCONTINUITIES IN AN ELECTRICAL NETWORK

(30) Priorité: 10.05.2013 FR 1354226
(43) Date de publication de la demande: 16.03.2016
(73) Titulaire: Safran Electrical & Power, 31702 Blagnac Cedex (FR)
(72) Inventeur: GENOULAZ, Jérôme, F-31840 Seilh (FR); ROQUES, Serge, Thierry, F-31700 Cornebarrieu (FR)
(74) Mandataire: Regimbeau
(86) Numéro de dépôt international: PCT/FR2014/051068
(87) Numéro de publication internationale: WO 2014/181066

(56) Documents cités:
- US-A- 5 754 053
- US-A1- 2011 169 498
- CYNTHIA FURSE ET AL: "Frequency-Domain Reflectometery for on-Board Testing of Aging Aircraft Wiring", IEEE TRANSACTIONS ON ELECTROMAGNETIC COMPATIBILITY, IEEE SERVICE CENTER, NEW YORK, NY, US, vol. 45, no. 2, 1 mai 2003 (2003-05-01), XP011072800, ISSN: 0018-9375
- Unknown: "Agilent 778D Dual Directional Coupler", , 11 September 2009 (2009-09-11), XP055451590, Retrieved from the Internet: URL:http://literature.cdn.keysight.com/lit web/pdf/5952-8133.pdf [retrieved on 2018-02-16]
- Unknown: "DUAL DIRECTIONAL COUPLER 10 kHz to 1 GHz", , 30 April 2008 (2008-04-30), XP055451595, Retrieved from the Internet: URL:www.teseq.com/products/downloads/datas heet/DCP_0100A.pdf [retrieved on 2018-02-16]
- Ronald D Rackley: "DIRECTIONAL COUPLER CONSTRUCTION DETAILS", , 31 January 2003 (2003-01-31), XP055451665, Retrieved from the Internet: URL:http://www.hatdaw.com/papers/DC_Constr uction_Details.pdf [retrieved on 2018-02-16]

## Description

### DOMAINE GENERAL

L'invention se rapporte au domaine de la détection de défauts dans un réseau électrique, notamment à celui de la détection de discontinuités par réflectométrie.

### ETAT DE L'ART

Pour détecter un défaut sur un conducteur électrique qui transporte un signal d'alimentation ou de donnée, une solution est la réflectométrie. Un signal électrique de test est injecté dans le conducteur électrique à l'aide d'un réflectomètre. En présence d'une discontinuité dans le conducteur électrique, ce signal de test est partiellement réfléchi et retourné au réflectomètre.

Un conducteur comprend typiquement une âme conductrice entourée par une gaine isolante et comporte un contact (mâle ou femelle) en chacune de ses extrémités.

Les conducteurs électriques de la plupart des installations électriques sont regroupés ensemble pour former un câble monofilaire, bifilaire, trifilaire, etc., et une pluralité de câbles sont eux-mêmes assemblés dans un harnais. En chacune de ses extrémités, un harnais dispose donc d'une pluralité de contacts destiné à être raccordée électriquement à une pluralité de contacts d'un autre équipement.

Pour injecter un signal de test, il s'avère généralement nécessaire de déconnecter une des extrémités du harnais qui contient le conducteur électrique à tester pour avoir accès à un contact de ce conducteur.

Après déconnexion du connecteur, localisation d'un défaut par réflectométrie et réparation du conducteur défectueux, il est nécessaire de réaliser des tests de fonctionnement du système ou équipement qui était électriquement lié au conducteur défectueux mais également sur tous les systèmes et équipements dont les conducteurs d'alimentation passent par le connecteur désaccouplé par le défaut.

Par ailleurs, des défauts intermittents peuvent apparaître dans une installation électrique soumise à des vibrations, par exemple dans le réseau d'alimentation d'un aéronef. Toutefois, ces défauts intermittents ne peuvent donc pas être détectés lors de tests réalisés alors que l'aéronef est en cours de maintenance au sol.

Pour éviter de telles déconnexions, il a été proposé d'utiliser des pinces d'injection de courant à induction.

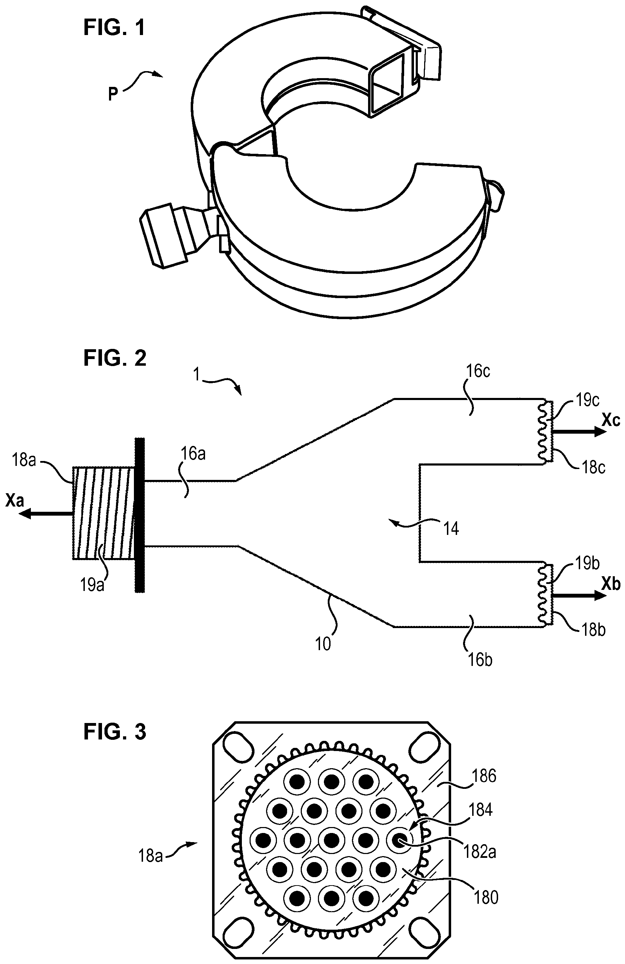

On a représenté en figure 1 une pince d'injection P connue de l'état de la technique. La pince P est adaptée pour venir enserrer un câble électrique à tester par réflectométrie. La pince émet un couplage par rayonnement électromagnétique sur le conducteur enserré, et génère un signal de test qui se propage dans le conducteur.

Toutefois, ce type de pince n'est pas adapté pour tester des harnais de câbles pourvus de protections électromagnétiques, qui ne laissent pas passer ce rayonnement entre l'extérieur et l'intérieur du câble. Ces protections doivent être retirées avant le test, voire même détruites si la conception des protections n'a pas envisagée cette possibilité, ce qui allonge la durée et le coût de l'intervention.

Par ailleurs, des harnais peuvent comprendre une grande quantité de câbles électriques maintenus serrés les uns aux autres. Or, l'introduction d'un pince telle que celle illustré en figure 1 risque d'endommager des conducteurs adjacents à celui destiné à être testé : d'une part, les câbles sont généralement liés entre eux par une frette ou un collier de serrage qu'il faut couper (premier risque d'endommagement), d'autre part, il faut ensuite écarter les conducteurs et placer la pince d'injection (second risque d'endommagement).

Les pinces telles que la pince P ne peuvent pas être placées sur des câbles torsadés, par exemple bifilaire, trifilaire, etc., sans détorsader le câble en ayant préalablement retiré puis ré-enfiché le contact du connecteur.

Le document US 2011/169498 A1 décrit un système de détection de l'emplacement de défauts d'arc dans le câblage d'un avion par injection de signaux de test dans un fil à tester via un élément de couplage capacitif connecté à une borne de raccordement et par analyse des signaux de test réfléchis pour déterminer la position du défaut d'arc.

### PRESENTATION DE L'INVENTION

L'invention vise à permettre de réaliser des tests impliquant une injection de signal dans un réseau électrique, sans avoir à déconnecter ni abîmer d'élément du réseau électrique.

Dans ce but, il est proposé un organe de connexion électrique, caractérisé en ce qu'il est apte à la détection de discontinuités dans un réseau électrique et comprend :
- une enveloppe à au moins trois branches, chacune des branches comportant à son extrémité au moins une borne de raccordement électrique à un équipement respectif,
- au moins un conducteur principal reliant dans l'enveloppe deux bornes aux extrémités de deux branches,
- au moins un conducteur secondaire reliant dans l'enveloppe au moins une borne de l'extrémité de la troisième branche et comprenant un coupleur électrique adapté pour injecter dans le conducteur principal un signal électrique de test en provenance du conducteur secondaire, et pour transmettre vers le conducteur secondaire un signal électrique de réponse généré par réflexion du signal électrique de test sur une discontinuité rencontrée dans le réseau électrique.

L'invention permet notamment de réaliser des tests par simple branchement d'un réflectomètre sur une extrémité secondaire de l'organe, et donc de réduire le coût et la durée d'un test de détection de défauts tels que des courts circuits ou des circuits ouverts.

Par ailleurs, l'organe permet de réaliser des tests de réflectométrie sur une ligne électrique en état de fonctionnement. Ceci est particulièrement avantageux car des discontinuités peuvent apparaître dans certaines installations électriques soumises à des perturbations que lorsqu'elles sont mises en fonctionnement, par exemple dans le réseau d'alimentation électrique d'un aéronef. L'organe de connexion permet alors de détecter des discontinuités survenant pendant le vol de l'aéronef, voire des discontinuités n'apparaissant que de façon intermittente, qui sont très difficiles voire impossibles à détecter lors d'un test au sol.

L'invention concerne également un kit de détection de discontinuités dans un réseau électrique, le kit comprenant un organe de connexion électrique conforme à la description qui précède et un réflectomètre raccordé électriquement à au moins une borne d'une extrémité secondaire de l'organe.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :
- La figure 1, déjà discutée, représente une pince d'injection connue de l'art antérieur.
- La figure 2 est une vue extérieure de côté d'un organe de connexion électrique selon un premier mode de réalisation.
- La figure 3 est une vue de face d'une extrémité de l'organe de connexion électrique de la figure 2.
- La figure 4 est une vue en coupe d'un organe de connexion électrique qui ne correspond pas à l'invention.
- La figure 5a est une vue en perspective d'un coupleur selon un deuxième mode de réalisation.
- La figure 5b est une vue en coupe partielle d'un organe de connexion électrique comprenant des coupleurs selon le deuxième mode de réalisation.
- La figure 6 représente schématiquement un réseau électrique testé par réflectométrie au moyen d'un organe de connexion électrique conforme à l'invention.

Sur l'ensemble des figures, les éléments similaires portent des références identiques.

### DESCRIPTION DETAILLEE DE L'INVENTION

En référence à la **figure 2**, un organe 1 de connexion électrique d'équipements comprend une enveloppe 10.

L'enveloppe 10 assure une protection électromagnétique et/ou mécanique et/ou foudre et/ou hermétique d'éléments logés dans le logement interne 12.

Dans le mode de réalisation illustré en figure 2, l'enveloppe 10 présente une portion centrale 14 et plusieurs branches 16a-16c tubulaires.

Chaque branche 16a-16c s'étend depuis la portion centrale 14 jusqu'à une extrémité 18a-18c de l'organe 1 destinée à être raccordé à un équipement respectif. Les extrémités présentent des axes de raccordement respectifs de directions parallèles.

Une première branche 16a s'étend depuis la portion centrale 14 dans un sens Xa. Une deuxième branche 16b et une troisième branche 16c s'étendent depuis la portion centrale 14 dans des sens Xb, Xc opposés au sens Xa de la première branche 16a, formant ainsi une enveloppe 10 en « Y ».

Chaque extrémité 18a-18c comprend au moins une borne ou contact de raccordement électrique 182a-182c.

Parmi les extrémités de l'organe 1, deux au moins sont dites principales, et une au moins est dite secondaire.

Chaque extrémité principale 18a, 18b est destinée à être raccordé électriquement au moyen de bornes à un équipement électrique A, B respectif.

L'extrémité secondaire 18c est destinée à être raccordé électriquement au moyen de bornes à un dispositif 2 configuré pour détecter des discontinuités dans le réseau R, par exemple un réflectomètre.

Selon un mode de réalisation illustré en figure 3, chaque extrémité principale 18a, 18b présente une surface transversale 180 plane et sensiblement circulaire. Les bornes de raccordement 182a sont réparties sur la surface plane 180, et peuvent former un logement ou bien être en saillie par rapport à la surface plane. Chaque borne 182 est adaptée pour être connectée électriquement avec un élément de volume complémentaire présent sur un équipement (non illustré) destiné à être raccordé à l'organe 1.

L'extrémité secondaire 18c peut être réalisée de manière similaire.

Par ailleurs, chaque extrémité 18a-18c peut comporter des moyens de raccordement mécanique 19 complémentaires afin de maintenir en place la liaison électrique réalisée entre chaque borne 182a-182c de l'organe 1 et chaque élément complémentaire de l'équipement raccordé correspondant. Par exemple, l'extrémité présente une collerette formant une embase et un filetage externe. Le filetage est destiné à recevoir une fiche complémentaire alors que la collerette est destinée à fixer le connecteur sur une structure ou un équipement.

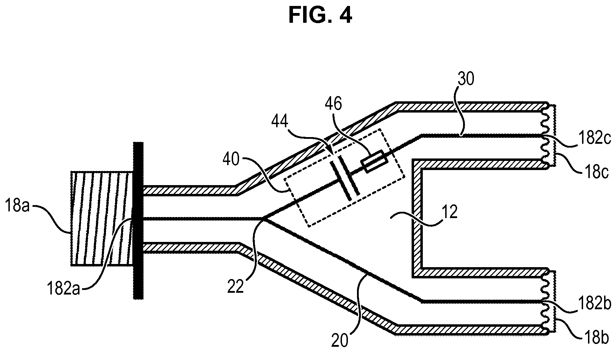

En référence à la **figure 4**, l'organe 1 comprend également un logement interne 12 relié à chaque extrémité de l'organe 1.

L'organe 1 comprend au moins deux conducteurs électriques 20, 30 s'étendant dans le logement interne 12. Chaque conducteur électrique peut typiquement être un câble comprenant une âme et une gaine de protection s'étendant autour de l'âme.

L'organe 1 comprend au moins un conducteur principal 20 reliant une première borne principale 182a d'une première extrémité principale 18a, avec une deuxième borne 182b d'une deuxième extrémité principale 18b. Chaque conducteur principal 20 est prévu pour transporter un signal électrique entre la première borne 182a et la deuxième borne 182b. L'organe 1 comprend en outre au moins un conducteur secondaire 30 logé dans le logement interne 12. Le conducteur secondaire 30 est connecté d'une part à au moins une borne secondaire 182c présente sur une extrémité secondaire 18c de l'organe 1, et d'autre part à un coupleur électrique 40 également logé dans le logement interne 12. Chaque conducteur secondaire 30 est prévu pour transporter un signal électrique entre une borne secondaire 182c et un coupleur 40 correspondants.

Dans l'organe de connexion électrique illustré en figure 4 présentant une enveloppe 10 en forme de Y, l'extrémité 18a opposée aux extrémités 18b et 18c est une extrémité principale 18a, 18b.

Chaque coupleur électrique 40 est associé à un conducteur principal 20.

Chaque coupleur 40 est adapté pour injecter dans le conducteur principal 20 associé un signal électrique de test en provenance du conducteur secondaire 30 connecté.

Chaque coupleur 40 est par ailleurs adapté pour détecter un signal de test qui transite dans un conducteur principal 20, et le transmettre le troisième signal électrique au conducteur secondaire 30 connecté, jusqu'à la borne secondaire correspondante.

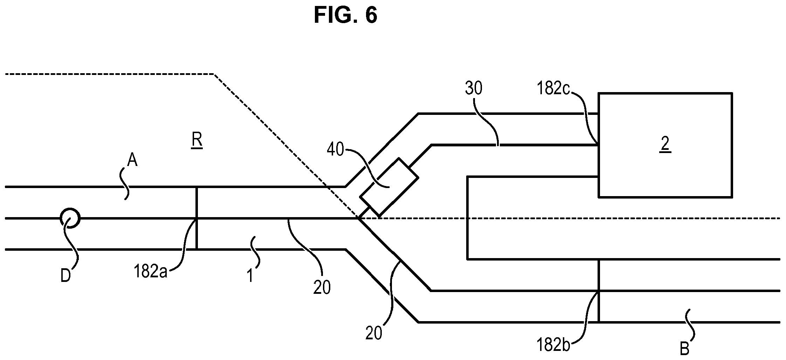

Dans un mode de réalisation illustré en figure 6, l'organe 1 comprend un conducteur principal 20, un conducteur secondaire 30 connecté à un coupleur 40, lequel coupleur 40 est associé au conducteur principal 20. Autre que selon l'invention, le coupleur de l'organe de connexion électrique illustré en figure 4 est un coupleur capacitif comprenant un condensateur 44 raccordé directement à un point de jonction 22 du conducteur principal 20, par exemple par soudage.

Le condensateur 44 peut typiquement être un condensateur film ou tantale. Le coupleur électrique 40 peut également comprendre un filtre 46 adapté pour laisser passer les signaux électriques de test et de réponse, et pour filtrer un signal électrique fonctionnel qui transite sur un conducteur principal 20.

Le filtre 46 peut être par exemple un filtre 46 passe-haut adapté pour filtrer un signal fonctionnel basse fréquence qui transite sur le conducteur principal 20.

Le filtre 46 peut être un composant placé sur le conducteur secondaire, en amont ou en aval du condensateur 44. En variante non illustré, le condensateur et le filtre sont un seul et même composant; le condensateur est alors adapté pour assurer le filtrage décrit.

L'organe 1 peut être utilisé pour détecter des défauts dans un réseau électrique.

En référence à la **figure 6**, l'organe 1 est raccordé électriquement à un premier équipement A par sa première extrémité principale 18a, à un deuxième équipement B par sa deuxième extrémité principale 18b. Un réseau électrique commun R comprenant au moins les dispositifs A, B et le conducteur principal 20 de l'organe 1 est alors créé.

L'organe 1 est par ailleurs raccordé électriquement par son extrémité secondaire 18c à un dispositif 2 destiné à la détection de discontinuités dans le réseau commun R, tel qu'un réflectomètre.

L'organe 1 et le réflectomètre 2 constituent ensemble un kit de détection de discontinuités dans le réseau électrique R.

Dans un premier mode de détection, aucun des premier et deuxième équipements A, B connectés à l'organe 1 ne délivre de signal électrique à l'organe 1 ; aucun signal électrique fonctionnel ne transite sur le conducteur principal 20 de l'organe 1.

En début de test, le réflectomètre 2 délivre un signal électrique de test en la borne secondaire 182c à laquelle il est connecté.

Ce signal électrique de test est transporté sur le conducteur électrique secondaire 30, puis injecté dans le conducteur principal 20 au point de jonction 22 par l'intermédiaire du coupleur 40.

Le signal de test se propage vers la première borne principale 182a, puis dans le premier équipement A connecté ; il se propage également vers la deuxième borne principale 182b, est dans le deuxième équipement B connecté.

Le signal de test rencontre une discontinuité D dans le réseau R (ici présente dans le premier équipement A). Une partie de l'énergie du signal de test est réfléchie par la discontinuité D, générant ainsi un signal électrique de réponse en direction du point de jonction 22.

Le signal électrique de réponse réfléchi atteint le point de jonction 22, est transmis sur le conducteur secondaire 30 par l'intermédiaire du coupleur 40, atteint la borne secondaire 182c et est enfin capté par le réflectomètre 2 connecté.

Dans un deuxième mode de détection, les équipements sont en cours de fonctionnement : un signal électrique fonctionnel circule alors dans le réseau commun R.

Ce signal fonctionnel provient d'un des premier ou deuxième équipements A ou B ; il peut s'agir par exemple un signal d'alimentation généré par le premier équipement A connecté, ou d'un signal de données.

Si le coupleur 40 comprend un filtre 46 tel que décrit précédemment, alors le signal fonctionnel n'est pas transmis au conducteur secondaire 30. Le conducteur secondaire 30, ainsi que le dispositif 2 raccordé en l'extrémité secondaire 18c sont donc isolés du signal électrique fonctionnel.

Lorsque le réflectomètre 2 délivre un signal électrique de test, ce signal de test est injecté dans le conducteur principal 20 au moyen du coupleur 40, et se superpose au signal électrique fonctionnel.

Par ailleurs, le signal de réponse réfléchi par la présence d'une discontinuité dans le réseau commun se superpose également au signal électrique fonctionnel.

Le signal de réponse est transmis par le coupleur électrique 40 sur le conducteur secondaire 30, puis au réflectomètre, mais pas le signal fonctionnel qui est filtré pour ne pas endommager le réflectomètre.

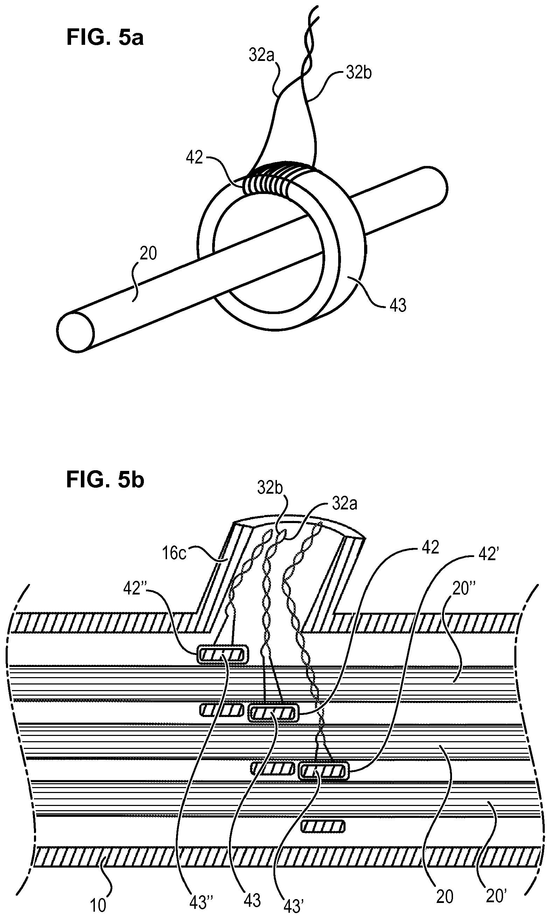

Dans un autre mode de réalisation illustré en **figures 5a et 5b**, le coupleur 40 utilisé est un coupleur inductif. Bien que non illustré, le coupleur inductif peut comprendre un filtre 46 tel que décrit précédemment.

Le coupleur 40 inductif comprend un bobinage 42 et un élément magnétique 43.

L'élément magnétique 43 s'étend tout autour d'une portion d'un conducteur principal 20. Il est typiquement de forme torique.

Le conducteur secondaire 30 est un fil comprenant une portion enroulée selon un sens de rotation autour d'une portion de l'élément magnétique 43, la portion enroulée formant ainsi un bobinage 42.

Le conducteur comprend par ailleurs deux portions de fil 32a, 32b jointes chacune au bobinage 42 et à une borne secondaire 182c de l'extrémité secondaire 18c.

Lorsqu'un signal de test délivré par le réflectomètre parvient au bobinage 42, celui-ci créé un champ magnétique canalisé par l'élément magnétique 43. La circulation de ce champ autour du conducteur principal 20, crée un signal électrique de test qui se propage dans le conducteur principal 20.

Lorsqu'un coupleur inductif est utilisé, il n'y a pas de transmission de signal électrique par contact en un point de soudage, mais par rayonnement (couplage).

De préférence, le coupleur inductif est configuré pour créer un champ magnétique d'orientation parallèle au conducteur principal 20 afin d'améliorer la transmission de signal électrique par couplage. Pour ce faire, un élément magnétique 43 de forme torique peut être disposé de façon à ce que son axe soit parallèle au conducteur principal, et le bobinage peut être enroulé autour de l'élément magnétique selon une direction sensiblement parallèle au conducteur principal.

Si le conducteur principal 20 comprend une âme protégée par une gaine, il n'y a pas besoin de dénuder cette gaine en un quelconque point de jonction pour assurer une communication électrique entre le bobinage 42 et le conducteur principal 20, dès lors que la gaine du conducteur principal 20 est adaptée pour être traversée par le rayonnement électromagnétique émis par le bobinage 42.

Les deux portions de fil 32a, 32b de chaque conducteur secondaire 30 sont torsadés ensemble, de manière à éviter des couplages par diaphonie entre plusieurs conducteurs secondaires.

Dans le mode de réalisation illustré en figure 5b, l'organe comprend trois conducteurs principaux 20, 20', 20", trois bobinages 42, 42', 42" respectifs, et trois éléments magnétiques 43, 43', 43" respectifs.

Les conducteurs principaux 20, 20', 20" s'étendent parallèlement dans le logement interne 12.

Dans les modes de réalisations illustrés, chaque coupleur 40 est associé à un seul conducteur principal 20 respectif. Un signal de test délivré par le dispositif 2 ne testera donc qu'une ligne électrique.

En variante, chaque coupleur 40 peut être associé à plusieurs conducteurs principaux. Ainsi, un seul et même signal de test émis par un réflectomètre se propagera dans plusieurs conducteurs principaux, ce qui réduit la durée du test.

Par exemple, un bobinage 42 conforme au deuxième mode de réalisation peut entourer plusieurs conducteurs principaux, et ainsi émettre un rayonnement électromagnétique qui atteindra tous les conducteurs principaux entourés.

L'organe 1 de connexion peut être utilisé dans un réseau électrique embarqué dans un aéronef, ou dans tout autre type d'installation sujette à l'apparition de discontinués intermittentes ou permanentes.

Le signal fonctionnel peut être un signal d'alimentation.

Des signaux d'alimentation couramment utilisé dans des aéronefs sont de fréquence continue, ou comprise entre 360 Hz et 800 Hz, typiquement 400 Hz. Dans ce contexte, le filtre 46 peut présenter une capacité de 33 nF dont la fréquence de coupure est de 100 kHz. Le filtre 46 laissera alors passer des signaux de test et de réponse dont la fréquence est supérieure à 100 kHz et bloquera le signal d'alimentation de fréquence inférieure à 100 kHz.

En variante, le signal fonctionnel peut être un signal de données. Dans ce cas, le coupleur 40 et le filtre 46 si présente seront dimensionnés pour présenter une impédance qui ne perturbe pas la transmission des données.

Chaque extrémité secondaire 18c peut être raccordée de façon permanente à un réflectomètre 2, lequel pourra être sollicité régulièrement pour détecter des discontinuités dans le réseau électrique commun, par exemple pendant le vol d'un aéronef.

En variante, chaque extrémité secondaire 18c peut être raccordée de façon intermittente à un réflectomètre 2. Dans ce cas, l'organe 1 peut comprendre des moyens 17 d'isolation mécanique et/ou électrique amovibles placés sur l'extrémité secondaire 18c, afin de prévenir l'introduction de poussière, fluide, etc. par les bornes secondaires dans l'organe 1 et sécuriser l'installation électrique, lorsqu'aucun dispositif 2 n'est raccordé à l'extrémité secondaire 18c.

Ces moyens d'isolation 17 peuvent être adaptés pour coopérer avec les moyens de raccordement mécaniques 19 présents sur l'extrémité secondaire 18c. Par exemple, les moyens d'isolation sont des capuchons et les moyens de raccordement mécanique des filetages sur la surface externe de l'enveloppe 10.

L'organe 1 peut bien entendu présenter plus d'une branche secondaire et plus de deux branches principales 16a, 16b.

Par ailleurs, dans les modes de réalisations d'enveloppe 10 en forme de « Y » illustrés sur les figures, la première branche s'étendant dans le sens Xa est une extrémité principale 18a, 18b. En variante, l'extrémité 18a opposée aux deux autres extrémités peut être une extrémité secondaire 18c.

D'autres orientations de branches pour un organe 1 à trois branches 16a-16c sont également possibles, par exemple en « T » (dans lequel les axes de raccordement de deux branches sont confondus), ou bien en étoile à trois branches (chaque axe de raccordement forme un angle de 120° avec chacun des deux autres axes de raccordement).

## Revendications

1. Organe (1) de connexion électrique, apte à la détection de discontinuités (D) dans un réseau électrique (R) et comprenant :
- une enveloppe (10) à au moins trois branches (16a-16c), chacune des branches comportant à son extrémité (18a-18c) au moins une borne (182a-182c) de raccordement électrique à un équipement respectif (A, B, 2),
- au moins un conducteur principal (20, 20', 20") reliant dans l'enveloppe (10) deux bornes (182a, 182b) aux extrémités (18a, 18b) de deux branches (16a, 16b),
- au moins un conducteur secondaire (30) reliant dans l'enveloppe (10) au moins une borne (182c) de l'extrémité (18c) de la troisième branche (16c) et comprenant un coupleur électrique (40) adapté pour injecter dans le conducteur principal (20, 20', 20") un signal électrique de test en provenance du conducteur secondaire (30), et pour transmettre vers le conducteur secondaire (30) un signal électrique de réponse généré par réflexion du signal électrique de test sur une discontinuité (D) rencontrée dans le réseau électrique (R),
dans lequel chaque coupleur électrique (40) comprend un élément magnétique (43, 43', 43") s'étendant autour d'une portion d'un conducteur principal (20, 20', 20"), et chaque conducteur secondaire (30) est un fil comprenant une portion de fil enroulée autour d'une portion de l'élément magnétique (43, 43', 43") correspondant formant ainsi un bobinage (42, 42', 42"), et deux portions de fil (32a, 32b) joignant chacune le bobinage (42, 42', 42") à une borne (182c) de l'extrémité (18c) de la troisième branche (16c), et dans lequel les deux portions de fil (32a, 32b) de chaque conducteur secondaire (30) forment ensemble une torsade.

2. Organe (1) selon la revendication 1, dans lequel chaque coupleur (40) est un coupleur inductif.

3. Organe (1) selon l'une des revendications 1 ou 2, dans lequel chaque coupleur (40) comprend un filtre (46) passe-haut adapté pour laisser passer les signaux électriques de test et de réponse, et adapté pour filtrer un signal électrique fonctionnel à basse fréquence qui transite sur le conducteur principal (20, 20', 20") correspondant.

4. Organe (1) selon l'une des revendications précédentes, comprenant en outre un capuchon amovible adapté pour couvrir l'extrémité comprenant la borne (18c) de raccordement au réflectomètre (2).

5. Organe (1) selon la revendication 4, dans lequel le capuchon comprend un isolant électrique.

6. Organe (1) selon l'une des revendications 4 ou 5, dans lequel l'extrémité (18c) de la troisième branche (16c) comporte un filetage, le capuchon étant adapté pour être vissé sur le filetage.

7. Organe (1) selon l'une des revendications précédentes, dans lequel l'enveloppe comprend une protection électromagnétique et/ou une protection contre la foudre.

8. Kit de détection de discontinuités (D) dans un réseau électrique (R), le kit comprenant un organe (1) de connexion électrique selon l'une des revendications 1 à 7 et un réflectomètre (2) raccordé électriquement à au moins une borne (182c) de l'extrémité (18c) de la troisième branche (16c).

9. Réseau électrique (R) comprenant un organe (1) selon l'une des revendications 1 à 7 et au moins deux équipements (A, B), chaque équipement (A, B) étant raccordé électriquement à au moins une borne (182a, 182b) d'une extrémité principale (18a, 18b) respective de l'organe (1).

10. Réseau électrique (R) d'alimentation d'aéronef conforme à la revendication 9.

11. Procédé de détection de discontinuités dans un réseau électrique (R) d'alimentation d'aéronef comprenant des étapes de :
- raccordement électrique de deux équipements (A, B) du réseau (R) à deux bornes (182a, 182b) d'un organe (1) de connexion électrique selon l'une des revendications 1 à 7, les deux bornes (182a, 182b) étant reliées entre elles par un conducteur principal (20, 20', 20"),
- raccordement électrique d'un réflectomètre (2) à au moins une borne (182c) de l'organe (1) connectée à un conducteur secondaire (30),
- émission par le réflectomètre (2) d'un signal électrique de test dans le conducteur secondaire (30),
- injection du signal électrique de test dans le conducteur principal (20, 20', 20") en provenance du conducteur secondaire (30),
- transmission vers le conducteur secondaire (30) d'un signal électrique de réponse généré par réflexion du signal électrique de test sur une discontinuité (D) rencontrée dans le réseau électrique (R).

## Patentansprüche

1. Elektrisches Verbindungselement (1), das zur Ermittlung von Diskontinuitäten (D) in einem elektrischen Netz (R) imstande ist und umfasst:
- ein Gehäuse (10) mit mindestens drei Abzweigungen (16a-16c), wobei jede der Abzweigungen an ihrem Ende (18a- 18c) mindestens eine elektrische Anschlussklemme (182a-182c) an eine jeweilige Ausrüstung (A, B, 2) aufweist,
- mindestens einen Hauptleiter (20, 20', 20"), der im Gehäuse (10) zwei Klemmen (182a, 182b) mit den Enden (18a, 18b) von zwei Abzweigungen (16a, 16b) verbindet,
- mindestens einen Sekundärleiter (30), der im Gehäuse (10) mindestens eine Klemme (182c) des Endes (18c) der dritten Abzweigung (16c) verbindet und eine elektrischen Koppler (40) umfasst, der geeignet ist, in den Hauptleiter (20, 20', 20") ein vom Sekundärleiter (30) kommendes elektrisches Testsignal einzuleiten und zur Übertragung eines elektrischen Antwortsignals, das durch Reflexion des elektrischen Testsignals an einer im elektrischen Netz (R) angetroffenen Diskontinuität (D) erzeugt wird, an den Sekundärleiter (30),
wobei jeder elektrische Koppler (40) ein Magnetelement (43, 43', 43") umfasst, das sich um einen Abschnitt eines Hauptleiters (20, 20', 20") erstreckt, und jeder Sekundärleiter (30) ein Draht ist, der einen um einen Abschnitt des entsprechenden Magnetelements (43, 43', 43") gewickelten Drahtabschnitt umfasst, wodurch eine Wicklung (42, 42', 42") gebildet wird, und zwei Drahtabschnitte (32a, 32b) jeweils die Wicklung (42, 42', 42") mit einer Klemme (182c) des Endes (18c) der dritten Abzweigung (16c) verbinden, und wobei die zwei Drahtabschnitte (32a, 32b) jedes Sekundärleiters (30) gemeinsam eine Verdrillung bilden.

2. Element (1) nach Anspruch 1, wobei jeder Koppler (40) ein induktiver Koppler ist.

3. Element (1) nach einem der Ansprüche 1 oder 2, wobei jeder Koppler (40) einen Hochpassfilter (46) umfasst, der zum Hindurchlassen der elektrischen Test-und Antwortsignale geeignet ist und geeignet, ein funktionales elektrisches Niederfrequenz-Signal zu filtern, das den den entsprechenden Hauptleiter (20, 20', 20") durchquert.

4. Element (1) nach einem der vorangehenden Ansprüche, umfassend ferner eine lösbare Kappe, die zum Abdecken des Endes geeignet ist, umfassend die Anschlussklemme (18c) an das Reflektometer (2).

5. Element (1) nach Anspruch 4, wobei die Kappe eine elektrische Isolation umfasst.

6. Element (1) nach einem der Ansprüche 4 oder 5, wobei das Ende (18c) der dritten Abzweigung (16c) ein Gewinde aufweist, wobei die Kappe zum Schrauben auf das Gewinde geeignet ist.

7. Element (1) nach einem der vorangehenden Ansprüche, wobei das Gehäuse einen elektromagnetischen Schutz und/oder einen Schutz gegen Blitzschlag umfasst.

8. Set für die Ermittlung von Diskontinuitäten (D) in einem elektrischen Netz (R), wobei das Set ein elektrisches Verbindungselement (1) nach einem der Ansprüche 1 bis 7 und ein Reflektometer (2) umfasst, das mit mindestens einer Klemme (182c) des Endes (18c) der dritten Abzweigung (16c) elektrisch verbunden ist.

9. Elektrisches Netz (R), umfassend ein Element (1) nach einem der Ansprüche 1 bis 7 und mindestens zwei Ausrüstungen (A, B), wobei jede Ausrüstung (A, B) mit mindestens einer Klemme (182a, 182b) eines jeweiligen Hauptendes (18a, 18b) des Elements (1) elektrisch verbunden ist.

10. Elektrisches Versorgungsnetz (R) eines Luftfahrzeugs nach Anspruch 9.

11. Verfahren zum Ermitteln von Diskontinuitäten in einem elektrischen Versorgungsnetz (R) eines Luftfahrzeugs, umfassend die Schritte:
- elektrisches Anschließen von zwei Ausrüstungen (A, B) des Netzes (R) an zwei Klemmen (182a, 182b) eines elektrischen Verbindungselements (1) nach einem der Ansprüche 1 bis 7, wobei die zwei Klemmen (182a, 182b) mittels eines Hauptleiters (20, 20', 20") miteinander verbunden sind,
- elektrisches Anschließen eines Reflektometers (2) an mindestens eine Klemme (182c) des Elements (1), die mit einem Sekundärleiter (30) verbunden ist,
- Senden, mittels des Reflektometers (2), eines elektrischen Testsignals in den Sekundärleiter (30),
- Einspeisen des vom Sekundärleiter (30) kommenden elektrischen Testsignals in den Hauptleiter (20, 20', 20"),
- Übertragen eines elektrischen Antwortsignals, das durch Reflexion des elektrisches Testsignals erzeugt wurde, über eine in dem elektrischen Netz (R) angetroffene Diskontinuität (D) an den Sekundärleiter (30) .

## Claims

1. An electrical connection member (1), capable of detecting discontinuities (D) in an electrical network (R) and comprising:
- an enclosure (10) with at least three branches (16a-16c), each of the branches including at its end (18a-18c) at least one terminal (182a-182c) for electrical connection to a respective equipment (A, B, 2),
- at least one main conductor (20, 20', 20") linking in the enclosure (10) two terminals (182a, 182b) at the ends (18a, 18b) of two branches (16a, 16b),
- at least one secondary conductor (30) linking in the enclosure (10) at least one terminal (182c) of the end (18c) of the third branch (16c) and comprising an electrical coupler (40) adapted to inject into the main conductor (20, 20', 20") an electrical test signal coming from the secondary conductor (30), and to transmit towards the secondary conductor (30) an electrical response signal generated by reflection of the electrical test signal on a discontinuity (D) encountered in the electrical network (R),
wherein each electrical coupler (40) comprises a magnetic element (43, 43', 43") extending around a portion of a main conductor (20, 20', 20"), and each secondary conductor (30) is a wire comprising a wire portion wound around a portion of the corresponding magnetic element (43, 43', 43") thus forming a coil (42, 42', 42"), and two wire portions (32a, 32b) each joining the coil (42, 42', 42") to a terminal (182c) of the end (18c) of the third branch (16c), and wherein the two wire portions (32a, 32b) of each secondary conductor (30) together form a twist.

2. The member (1) according to claim 1, wherein each coupler (40) is an inductive coupler.

3. The member (1) according to any of claim 1 or 2 wherein each coupler (40) comprises a high-pass filter (46) adapted to pass the electrical test and response signals, and adapted to filter a low-frequency functional electrical signal which travels on the corresponding main conductor (20, 20', 20").

4. The member (1) according to any of the preceding claims, further comprising a removable cap adapted to cover the end comprising the terminal (18c) for connection to the reflectometer (2).

5. The member (1) according to claim 4 wherein the cap comprises an electrical insulator.

6. The member (1) according to any of claims 4 or 5, wherein the end (18c) of the third branch (16c) includes a thread, the cap being adapted to be screwed onto the thread.

7. The member (1) according to any of the preceding claims, wherein the enclosure comprises an electromagnetic protection and/or a protection against lightning.

8. A kit for detecting discontinuities (D) in an electrical network (R), the kit comprising an electrical connection member (1) according to any of claims 1 to 7 and a reflectometer (2) electrically connected to at least one terminal (182c) of the end (18c) of the third branch (16c).

9. An electrical network (R) comprising a member (1) according to any of claims 1 to 7 and at least two pieces of equipment (A, B), each piece of equipment (A, B) being electrically connected to at least one terminal (182a, 182b) of a respective main end (18a, 18b) of the member (1).

10. An aircraft power supply network (R) in accordance with claim 9.

11. A method for detecting discontinuities in an aircraft power supply network (R) comprising the steps of:
- electrically connecting two pieces of equipment (A, B) of the network (R) to two terminals (182a, 182b) of an electrical connection member (1) according to any of claims 1 to 7, the two terminals (182a, 182b) being linked to each other by a main conductor (20, 20', 20"),
- electrically connecting a reflectometer (2) to at least one terminal (182c) of the member (1) connected to a secondary conductor (30),
- emitting by the reflectometer (2) an electrical test signal in the secondary conductor (30),
- injecting the electrical test signal into the main conductor (20, 20', 20") coming from the secondary conductor (30),
- transmitting towards the secondary conductor (30) an electrical response signal generated by reflection of the electrical test signal on a discontinuity (D) encountered in the electrical network (R).
